# EUROPEAN PATENT APPLICATION

(11) **EP 3 226 061 A2**
(43) Date of publication of application: **04.10.2017**
(21) Application number: 17158320.6
(22) Date of filing: 28.02.2017
(51) Int. Cl.: G02B 27/01, G02B 5/02, H01L 51/52

(54) **HEAD-MOUNTED DISPLAY DEVICE**

(30) Priority: 09.03.2016 KR 20160028477
(71) Applicant: Samsung Display Co., Ltd., Gyeonggi-Do (KR)
(72) Inventor: Kim, Jae-Kyoung, Gyeonggi-do (KR); Kang, Seockhwan, Seoul (KR); Kim, Kiseo, Gyeonggi-do (KR); Park, Wonsang, Gyeonggi-do (KR)
(74) Representative: Gulde & Partner

(57) **Abstract**

A head-mounted display device (HMD) includes a display panel (DP) including a plurality of pixels (PX1, PX2, PX3) for displaying an image, a filter (SF, SF1) on the display panel (DP) including a scattering layer (OF1, AL2) for scattering the image to generate a scattered image, the scattering layer (OF1, AL2) including a base (BS1, BS2) having a first refractive index, and scattering particles (CU1, DB1) within the base (BS1, BS2) and having a second refractive index that is greater than the first refractive index, and an optical system (OL) in front of the filter (SF, SF1) for magnifying the scattered image.

## Description

### CROSS-REFERENCE TO RELATED APPLICATION

This application claims priority to, and the benefit of, Korean Patent Application No. 10-2016-0028477.

### BACKGROUND

### 1. Field

The present disclosure relates to a head-mounted display device having improved display quality.

### 2. Description of the Related Art

A head-mounted display device is a display device that can be mounted on a head of a user, and can be used to realize an augmented reality or a virtual reality. The head-mounted display device used for augmented reality provides a virtual graphic image through a semi-transparent display. In this case, the user simultaneously perceives the virtual graphic image on the display, and a real object through the display. The head-mounted display device used for virtual reality provides a virtual graphic image to an eye of the user. The user experiences the virtual reality through virtual contents.

### SUMMARY

The present disclosure provides a head-mounted display device having improved display quality.

Embodiments of the inventive concept provide a head-mounted display device including a display panel including a plurality of pixels for displaying an image, a filter on the display panel including a scattering layer for scattering the image to generate a scattered image, the scattering layer including a base having a first refractive index, and scattering particles mixed with the base and having a second refractive index that is greater than the first refractive index, and an optical system on the filter for magnifying the scattered image.

The filter may further include a surface treatment layer on the scattering layer for diffusing or canceling light reflected by the display panel.

The filter may further include a neutral density film layer on the scattering layer.

The filter may further include an adhesive layer between the scattering layer and the display panel to couple the scattering layer to the display panel.

Each of the scattering particles may have a bar shape elongated along a direction perpendicular to a surface of the display panel.

The base may include a urethane methacrylate oligomer.

The scattering particles may include ethoxylated o-phenylphenol acrylate.

The scattering particles may be spaced apart from each other by a distance of about 3 micrometers to about 4 micrometers.

Each of the scattering particles may have a bead shape.

The scattering particles may include main scattering particles having a first size that is smaller than a size of a smallest pixel among the pixels, and that is greater than about 700 nm.

The scattering particles may further include auxiliary scattering particles having a second size that is smaller than the first size.

The second size may be smaller than about 1 micrometer.

The main scattering particles and the auxiliary scattering particles may include a same material.

A concentration of the main scattering particles may be higher than a concentration of the auxiliary scattering particles.

The base may include poly-butyl acrylate.

The scattering particles may include one of melamine, polystyrene, polymethyl methacrylate, polylactide, silicon oxide, and metal oxide.

The scattering layer may further include dye particles mixed with the base.

The filter may further include a film on the scattering layer, wherein the film is a transparent film.

The film may be a colored transparent film.

According to the above, the phenomenon in which the non-pixel area is perceived by the user after being magnified may be reduced.

### BRIEF DESCRIPTION OF THE DRAWINGS

The above and other features of the present disclosure will become readily apparent by reference to the following detailed description when considered in conjunction with the accompanying drawings, wherein:
FIG. 1 is a perspective view showing a head-mounted display device according to an exemplary embodiment of the present disclosure;
FIG. 2 is a view showing a head-mounted display device worn on a head of a user according to an exemplary embodiment of the present disclosure;
FIG. 3 is an exploded perspective view showing a head-mounted display device according to an exemplary embodiment of the present disclosure;
FIG. 4 is a cross-sectional view showing a head-mounted display device and a representation of eyes of a user according to an exemplary embodiment of the present disclosure;
FIG. 5 is a plan view showing a display panel according to an exemplary embodiment of the present disclosure;
FIG. 6 is a cross-sectional view showing a filter according to an exemplary embodiment of the present disclosure;
FIG. 7 is a cross-sectional view showing a filter according to an exemplary embodiment of the present disclosure;
FIG. 8 is a cross-sectional view showing a filter according to an exemplary embodiment of the present disclosure;
FIG. 9 is a cross-sectional view showing a head-mounted display device and a representation of eyes of a user according to an exemplary embodiment of the present disclosure;
FIG. 10 is a graph showing a brightness variation as a function of a position variation on a display panel;
FIG. 11 is a cross-sectional view showing a filter according to an exemplary embodiment of the present disclosure;
FIG. 12 is a cross-sectional view showing a head-mounted display device and a representation of eyes of a user according to an exemplary embodiment of the present disclosure;
FIG. 13 is a cross-sectional view showing a filter according to an exemplary embodiment of the present disclosure;
FIG. 14 is a cross-sectional view showing a filter according to an exemplary embodiment of the present disclosure; and
FIG. 15 is a graph showing a brightness variation as a function of a position variation on a display panel.

### DETAILED DESCRIPTION

Features of the inventive concept and methods of accomplishing the same may be understood more readily by reference to the following detailed description of embodiments and the accompanying drawings. Hereinafter, example embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present invention.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that when an element, layer, region, or component is referred to as being "on," "connected to," or "coupled to" another element, layer, region, or component, it can be directly on, connected to, or coupled to the other element, layer, region, or component, or one or more intervening elements, layers, regions, or components may be present. In addition, it will also be understood that when an element or layer is referred to as being "between" two elements or layers, it can be the only element or layer between the two elements or layers, or one or more intervening elements or layers may also be present.

In the following examples, the first direction, the second direction and the third direction are not limited to three directions of a rectangular coordinate system, and may be interpreted in a broader sense. For example, the first direction, the second direction, and the third direction may be perpendicular to one another, or may represent different directions that are not perpendicular to one another.

The terminology used herein is for the purpose of describing particular embodiments only and is not intended to be limiting of the present invention. As used herein, the singular forms "a" and "an" are intended to include the plural forms as well, unless the context clearly indicates otherwise. It will be further understood that the terms "comprises," "comprising," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, the use of "may" when describing embodiments of the present invention refers to "one or more embodiments of the present invention." As used herein, the terms "use," "using," and "used" may be considered synonymous with the terms "utilize," "utilizing," and "utilized," respectively. Also, the term "exemplary" is intended to refer to an example or illustration.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

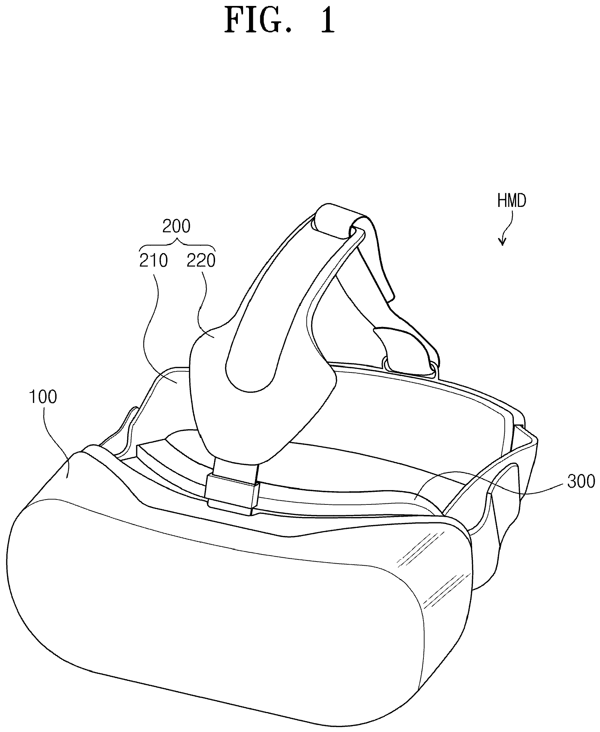

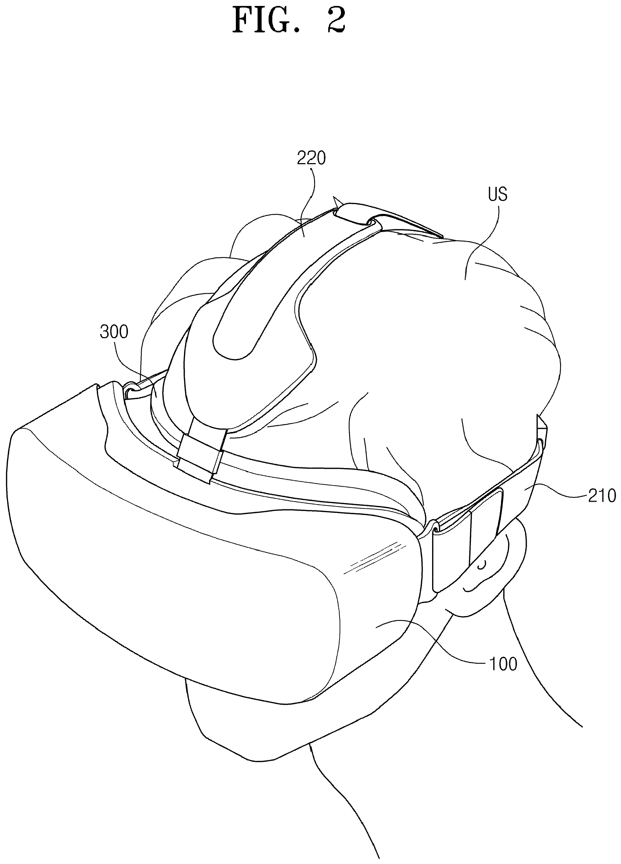

FIG. 1 is a perspective view showing a head-mounted display device HMD according to an exemplary embodiment of the present disclosure, and FIG. 2 is a view showing a head-mounted display device worn on a head of a user according to an exemplary embodiment of the present disclosure.

Referring to FIGS. 1 and 2, the head-mounted display device HMD is worn on the head of the user US. The head-mounted display device HMD provides the user with an image while peripheral vision of the user is blocked. The user wearing the head-mounted display device HMD may be immersed in virtual reality.

The head-mounted display device HMD includes a body part (e.g., a body) 100, a strap part (e.g., a strap) 200, and a cushion part (e.g., a cushion) 300.

The body part 100 is mounted on the head of the user US. The body part 100 accommodates a display panel unit for displaying the image, and an acceleration sensor therein. The acceleration sensor senses a movement of the user US, and applies a signal to the display panel unit. Accordingly, the display panel unit displays an image corresponding to a change in the user's movement. Therefore, the user US may experience the virtual reality as if it is real.

The body part 100 may accommodate components with various functions in addition to the above-mentioned components. For example, an operation part (e.g., control interfaces) may be additionally located on an outer portion of the body part 100 to control, for example, volume or screen brightness. The operation part may be a physical button or a touch sensor. In addition, the body part 100 may accommodate a proximity sensor to determine when the user US wears the head-mounted display device HMD.

The strap part 200 is coupled to the body part 100 to allow the user US to easily wear the body part 100. The strap part 200 may include a main strap 210 and an upper strap 220.

The main strap 210 is worn around the head of the user US. The main strap 210 fixes the body part 100 to the user US such that the body part 100 is adhered to the head of the user US. The upper strap 220 connects the body part 100 and the main strap 210 along an upper portion of the head of the user US. The upper strap 220 prevents the body part 100 from slipping down. In addition, the upper strap 220 distributes a weight of the body part 100 to improve comfort of the head-mounted display device HMD when worn on the head of the user US.

The main strap 210 and the upper strap 220 shown in FIG. 1 have a length that is adjustable by using a separate length control part, although they should not be limited thereto or thereby. That is, according to another embodiment, when the main strap 210 and the upper strap 220 have elasticity, the length control part may be omitted.

In the case that the body part 100 may be fixed to the user US, the strap part 200 of other embodiments may have a variety of shapes in addition to the shape shown in FIGS. 1 and 2. For example, the upper strap 220 may be omitted according to another embodiment. In addition, the strap part 200 may be provided in a helmet coupled to the body part 100, or in temples/bows of a pair of glasses coupled to the body part 100.

The cushion part 300 is between the body part 100 and the head or the face of the user US. The cushion part 300 includes a material that may be deformed. For instance, the cushion part 300 may include a polymer resin (e.g., polyurethane, polycarbonate, polypropylene, polyethylene, etc.), or a sponge formed by foam molding a rubber solution, a urethane-based material, or an acrylic-based material.

The cushion part 300 allows the body part 100 to be adhered, or fixed, to the user US, and thus the feeling of wearing the head-mounted display device HMD on the user may be improved. The cushion part 300 is detachable from, and attachable to, the body part 100. The cushion part 300 may be omitted according to another embodiment.

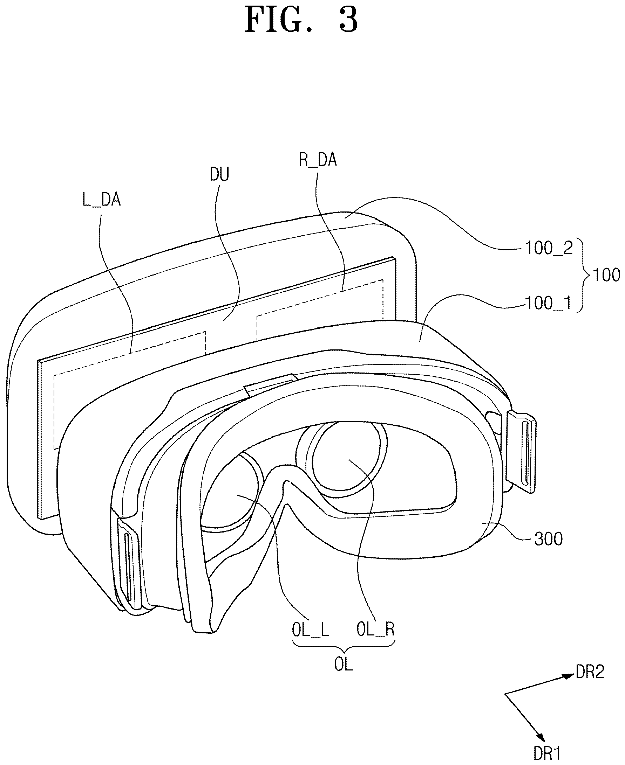

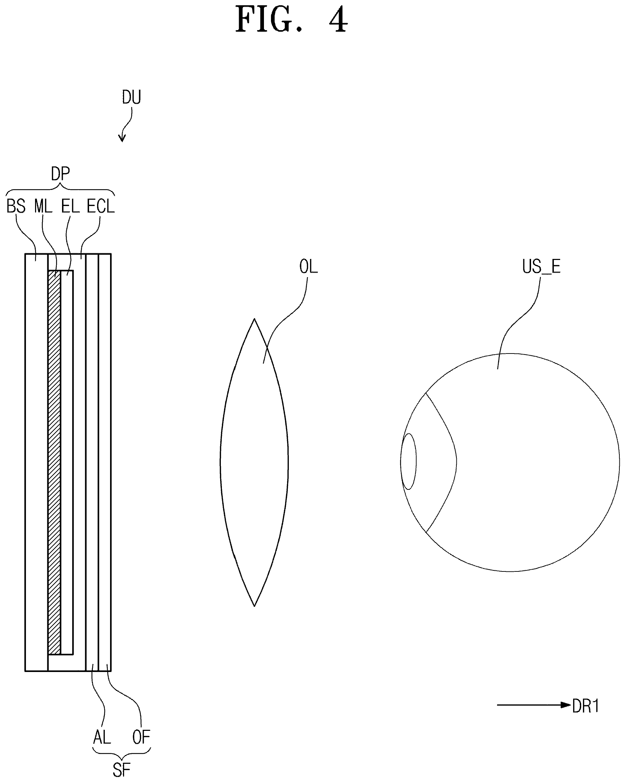

FIG. 3 is an exploded perspective view showing a head-mounted display device according to an exemplary embodiment of the present disclosure, and FIG. 4 is a cross-sectional view showing a head-mounted display device and a representation of eyes of a user according to an exemplary embodiment of the present disclosure. The strap part 200 (refer to FIG. 1) is not shown in FIG. 3. FIG. 4 shows only the display panel unit DU, the optical system OL, and the eyes of the user US_E.

Referring to FIGS. 3 and 4, the body part 100 includes a body portion (e.g., a body) 100_1 and a cover portion (e.g., a cover) 100_2, which are separated from each other. FIG. 3 shows the body portion 100_1, and the cover portion 100_2 separated from the body portion 100_1, but they should not be limited thereto or thereby. For instance, the body portion 100_1 and the cover portion 100_2 may be integrally formed with each other to be inseparable.

The display panel unit DU is between the body portion 100_1 and the cover portion 100_2. In FIG. 3, a left-eye image and a right-eye image are displayed through one display panel unit DU. The display panel unit DU includes a left-eye image display area L_DA through which a left-eye image is displayed, and a right-eye image display area R_DA through which a right-eye image is displayed. The left-eye image display area L_DA and the right-eye image display area R_DA may be driven by separate drivers, respectively, but they should not be limited thereto or thereby. That is, the left-eye image display area L_DA and the right-eye image display area R_DA may be driven by one driver. In addition, according to another embodiment, the display panel unit DU may include a left-eye display panel unit and a right-eye display panel unit, which are separated from each other.

The display panel unit DU includes a display panel DP and a filter SF. The display panel DP generates an image corresponding to image data input thereto. The display panel DP may be, but is not limited to, an organic light emitting display panel, a liquid crystal display panel, a plasma display panel, an electrophoretic display panel, or an electrowetting display panel. In the present exemplary embodiment, the display panel DP will be described as an organic light emitting display panel, but the display panel DP should not be limited thereto.

The display panel DP includes a base substrate BS, a circuit layer ML, an organic light emitting element layer EL, and an encapsulation layer ECL.

The base substrate BS includes at least one of a glass substrate, a sapphire substrate, and a plastic substrate. The circuit layer ML, the organic light emitting element layer EL, and the encapsulation layer ECL are located on the base substrate BS.

The circuit layer ML includes a plurality of signal lines and electronic devices, which are arranged on the display panel DP. For instance, the circuit layer ML includes gate lines, data lines, and thin film transistors respectively corresponding to pixels.

The organic light emitting element layer EL includes an organic light emitting layer containing a low molecular weight material or a high molecular weight organic material. The organic light emitting layer emits a light. The organic light emitting element layer EL may selectively include a hole transport layer (HTL), a hole injection layer (HIL), an electron transport layer (ETL), and an electron injection layer (EIL) in addition to the organic light emitting element layer.

The encapsulation layer ECL includes a thin film encapsulation layer (TFE) configured to include a plurality of inorganic thin film layers and a plurality of organic thin film layers. The encapsulation layer ECL covers the organic light emitting element layer EL, and blocks air and moisture to protect the organic light emitting element layer EL. In other embodiments, the encapsulation layer ECL may be replaced with an encapsulation substrate, which may be spaced apart from the base substrate BS such that the organic light emitting element layer EL is between the encapsulation substrate and the base substrate BS. The encapsulation layer and the base substrate BS are coupled to each other by a sealant arranged along an edge of the base substrate BS.

The filter SF is attached to a surface of the display panel DP on which an image is displayed. The filter SF includes a film OF and an adhesive layer AL. The adhesive layer AL is between the film OF and the display panel DP to attach the film OF to the display panel DP. In the present exemplary embodiment, the filter SF is located on the encapsulation layer ECL. According to another embodiment, the display panel DP is a rear surface light emitting type organic light emitting display panel, and the filter SF may be attached to the base substrate BS.

The filter SF scatters the image provided from the display panel DP to generate a scattered image. That is, the filter SF scatters or spreads the light provided from the display panel DP. In view of the pixel, the light provided from the display panel DP is scattered while passing through the filter SF, and as a result, an effective light emitting area (e.g., a perceived light emitting area) of the pixel may be increased. Details of the filter SF will be described later.

The optical system OL is inside the body portion 100_1 of the body part 100. The optical system OL magnifies the image provided from the display panel unit DU. The image provided from the display panel DP is scattered while passing through the filter SF, and the optical system OL magnifies the image passing through the filter SF.

The optical system OL is spaced apart from the display panel DP in a first direction DR1 in which the image is displayed from the display panel DP. The optical system OL is between the display panel DP and an eye US_E of the user US.

The optical system OL includes a right-eye optical system OL_R and a left-eye optical system OL_L. The left-eye optical system OL_L provides the image to a left pupil of the user US after magnifying the image, and the right-eye optical system OL_R provides the image to a right pupil of the user US after magnifying the image.

The left-eye optical system OL_L and the right-eye optical system OL_R are spaced apart from each other in a second direction DR2 that crosses the first direction DR1. A distance between the left-eye optical system OL_L and the right-eye optical system OL_R is controlled to correspond to a distance between two eyes US_E of the user US. In addition, a distance between the optical system OL and the display panel unit DU may be controlled in accordance with an eyesight of the user US.

The optical system OL may be a convex aspherical lens. In the present exemplary embodiment, each of the left-eye optical system OL_L and the right-eye optical system OL_R includes only one lens, but the number of the lenses of the left-eye optical system OL_L and the right-eye optical system OL_R is not limited to one in other embodiments. For instance, each of the left-eye optical system OL_L and the right-eye optical system OL_R may include a plurality of lenses.

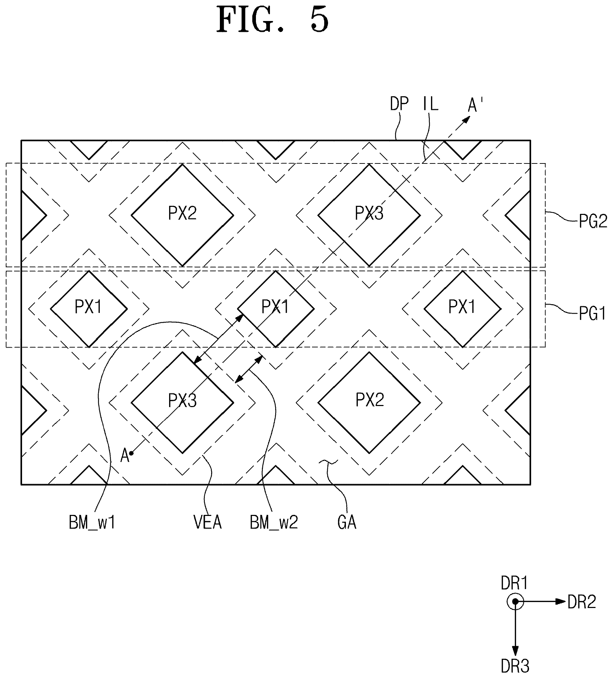

FIG. 5 is a plan view showing a display panel according to an exemplary embodiment of the present disclosure. FIG. 5 shows an enlarged portion of the display panel DP.

Referring to FIGS. 4 and 5, a first direction DR1 is substantially parallel to a thickness direction of the display panel DP. A second direction DR2 and a third direction DR3, which crosses the second direction DR2, each cross the first direction DR1. A plane defined by the second and third directions DR2 and DR3 may be substantially parallel to the surface of the display panel DP on which the image is displayed.

The display panel DP includes first pixel groups PG1 and second pixel groups PG2. The first pixel groups PG1 and the second pixel groups PG2 are alternately and repeatedly arranged along the third direction DR3.

The first pixel groups PG1 include a plurality of first pixels PX1. The first pixels PX1 are arranged along the second direction DR2. The second pixel groups PG2 include a plurality of second pixels PX2 and a plurality of third pixels PX3. The second pixels PX2 are alternately arranged with the third pixels PX3 along the second direction DR2.

An arrangement of the first, second, and third pixels PX1, PX2, and PX3 should not be limited to that shown in FIG. 5. For instance, the first, second, and third pixels PX1, PX2, and PX3 may be arranged in a stripe shape and alternately arranged along the second direction DR2, according to another embodiment. In addition, each of the first, second, and third pixels PX1, PX2, and PX3 has a rectangular shape in the present embodiment, but the shape of the first, second, and third pixels PX1, PX2, and PX3 should not be limited to the rectangular shape in other embodiments. That is, each of the first, second, and third pixels PX1, PX2, and PX3 may have a variety of shapes (e.g., a polygonal shape, a circular shape, an oval shape, etc.). In addition, although the first pixels PX1 have a size smaller than the second and third pixels PX2 and PX3 in the embodiment shown in FIG. 5, the first, second, and third pixels PX1, PX2, and PX3 may have the same size according to another embodiment.

In the present embodiment, the first pixels PX1 are green pixels, the second pixels PX2 are blue pixels, and the third pixels PX3 are red pixels, although they should not be limited thereto or thereby.

A non-pixel area GA is an area between respective ones of the first, second, and third pixels PX1, PX2, and PX3.

As described above, the optical system OL of the head-mounted display device HMD magnifies the image provided from the display panel unit DU. In this case, the non-pixel area GA may be magnified by the optical system OL just as the first, second, and third pixels PX1, PX2, and PX3 are magnified by the optical system OL. That is, a distance BM_w1 between adjacent pixels may be magnified to become large, and may be perceived by the user US. As a result, display quality of the head-mounted display device HMD may be degraded. However, according to the present exemplary embodiment, the filter SF is at a front portion of the display panel DP to magnify the effective light emitting area VEA of each of the first, second, and third pixels PX1, PX2, and PX3. Because the filter SF scatters the light provided from the first, second, and third pixels PX1, PX2, and PX3, it is perceived that the light is provided from individual areas that are larger than the corresponding actual areas of the first, second, and third pixels PX1, PX2, and PX3. Accordingly, a distance BM_w2 between the effective light emitting areas VEA of adjacent pixels may be smaller than the aforementioned distance BM_w1 between adjacent pixels. As a result, although the distance BM_w2 between the effective light emitting areas VEA is magnified by the optical system OL, the area between the effective light emitting areas VEA may not be perceived by the user US. Therefore, the display quality of the head-mounted display device HMD may be improved. Hereinafter, the structure of the filter SF will be described in detail.

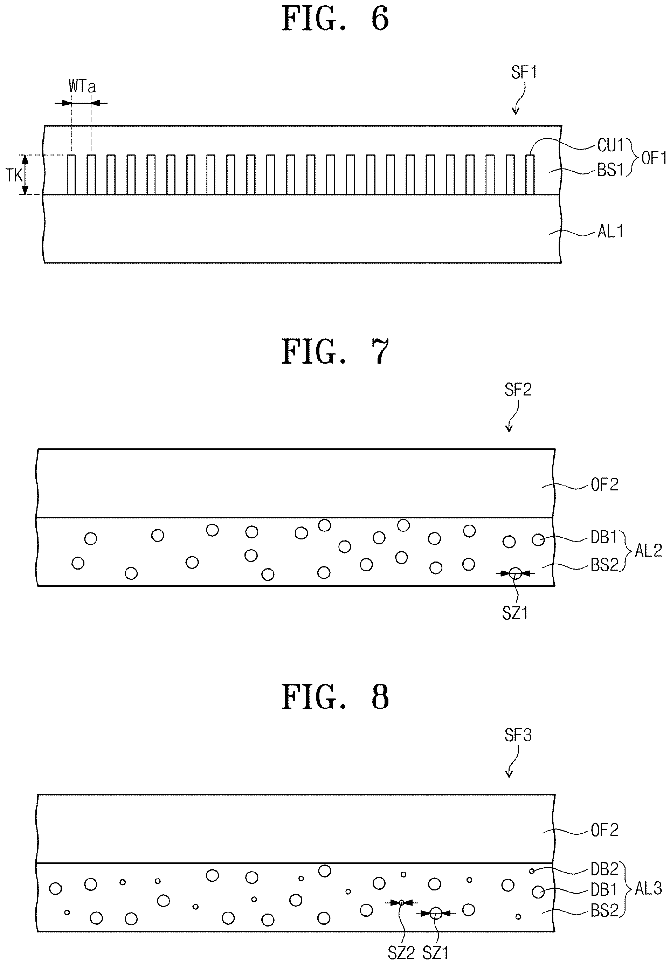

FIG. 6 is a cross-sectional view showing a filter SF1 according to an exemplary embodiment of the present disclosure.

Referring to FIGS. 4 and 6, the filter SF1 of the present embodiment includes an adhesive layer AL1 and a film OF1. In the present exemplary embodiment shown in FIG. 6, the film OF1 is referred to as a scattering layer.

The adhesive layer AL1 is interposed between the display panel DP and the scattering layer OF1 to attach the scattering layer OF1 to the display panel DP. The adhesive layer AL1 may be an optically clear adhesive film, but it should not be limited thereto or thereby. The adhesive layer AL1 may be an optical clear resin.

The scattering layer OF1 includes a base BS1 and scattering particles CU1. The scattering particles CU1 have a refractive index that is higher than a refractive index of the base BS1. For instance, the refractive index of the base BS1 may be about 1.48, and the refractive index of the scattering particles CU1 may be about 1.57.

The scattering particles CU1 may have a bar shape elongated in the first direction DR1 (e.g., a direction perpendicular to a surface of the display panel DP). The scattering particles CU1 may include a heat-curable resin or an ultraviolet-curable resin. For instance, the scattering particles CU1 may be, but are not limited to, ethoxylated o-phenylphenol acrylate.

The base BS1 may include a material in which a phase separation occurs when the scattering particles CU1 and the base BS1 are cured. For example, the base BS1 may include urethane methacrylate oligomer, although the base BS1 should not be limited thereto or thereby.

The phase separation may occur between the base BS1 and the scattering particles CU1 during the curing of the base BS1 and the scattering particles CU1. Accordingly, the scattering particles CU1 are grown in the first direction DR1 and have the bar shape. Because the scattering particles CU1 have the bar shape, a forward scattering phenomenon may easily occur.

Among the scattering particles CU1, a pitch WTa between two adjacent scattering particles may be in a range from about 3 micrometers to about 4 micrometers. It should be noted, however, that the pitch WTa between two scattering particles next to each other should not be limited thereto or thereby.

The scattering particles CU1 have a thickness TK (e.g., a thickness TK in the first direction DR1) of about 40 micrometers to about 200 micrometers, although the thickness TK of the scattering particles CU1 should not be limited thereto or thereby. For instance, the thickness TK of the scattering particles CU1 may be controlled by, or determined by, a resolution of the display panel DP.

In more detail, as the thickness TK of the scattering particles CU1 increases, an angle at which the light is scattered increases when viewed relative to a direction in which the incident light travels. When a high-resolution display panel is compared with a low-resolution display panel, an image display characteristic of the high-resolution display panel may be improved even though the high-resolution display panel has the scattering angle that is smaller than that of the low-resolution display panel. Accordingly, the thickness TK of the scattering particles CU1 of the filter SF1 applied to the high-resolution display panel may be smaller than the thickness TK of the scattering particles CU1 of the filter SF1 applied to the low-resolution display panel.

FIG. 7 is a cross-sectional view showing a filter SF2 according to an exemplary embodiment of the present disclosure.

Referring to FIG. 7, the filter SF2 of the present embodiment includes an adhesive layer AL2 and a film OF2, where the adhesive layer AL2 is referred to as a scattering layer.

The scattering layer AL2 includes a base BS2 and scattering particles DB1. The scattering particles DB1 have a refractive index that is higher than a refractive index of the base BS2. For instance, the refractive index of the base BS2 may be about 1.46, and the refractive index of the scattering particles DB1 may be about 1.54.

The scattering particles DB1 have a bead shape. The scattering particles DB1 include an organic material or an inorganic material. For instance, the scattering particles DB1 include one of melamine, polystyrene, polymethyl methacrylate (PMMA), polylactide, silicon oxide, and metal oxide. The metal oxide may be, for example, aluminum oxide, or titanium oxide, but the metal oxide should not be limited thereto or thereby.

The light provided from the display panel DP is incident to the scattering particles DB1, and is scattered to various directions. In a case where a size SZ1 (e.g., diameter) of the scattering particles DB1 is greater than a wavelength of the incident light, an amount of the light forward-scattered in the direction in which the incident light travels is greater than an amount of the light backward-scattered in a direction that is opposite to the traveling direction of the incident light. Accordingly, an efficiency of the light may not be reduced, and blurring of the image due to the scattering of the light may be prevented or reduced. Thus, the size SZ1 of the scattering particles DB1 in the present embodiment is greater than the wavelength of the light in the visible light spectrum which is typically in a range from about 390nm to about 700nm.

However, when the size SZ1 of the scattering particles DB1 increases, a sparkling phenomenon, in which the light provided from the display panel DP flashes or sparkles, may occur. To prevent the occurrence of the sparkling phenomenon, the size SZ1 of the scattering particles DB1 may be set to be smaller than a size of the smallest pixel among the pixels PX1 to PX3. For instance, when the size of the first pixel PX1 is smallest, the size SZ1 of the scattering particles DB1 may be smaller than the size of the first pixel PX1.

The size SZ1 of the scattering particles DB1 may be equal to, or greater than, 700 nanometers, and may be equal to, or smaller than, 10 micrometers. In more detail, the size SZ1 of the scattering particles DB1 may be in a range from about 2 micrometers to about 3 micrometers. In FIG. 7, the scattering particles DB1 have a constant size, but the scattering particles DB1 may have various sizes in the range from about 700 nanometers to about 10 micrometers according to another embodiment.

The base BS2 surrounds the scattering particles DB1. The base BS2 may be, but is not limited to, an optical clear resin. For instance, the base BS2 may include poly-butyl acrylate (PBA).

The film OF2 is attached to the scattering layer AL2. The film OF2 may be, but is not limited to, a transparent film, or may be a colored film containing dye particles.

FIG. 8 is a cross-sectional view showing a filter SF3 according to an exemplary embodiment of the present disclosure.

Referring to FIG. 8, the filter SF3 has the same structure and function as the filter SF2 of the embodiment shown in FIG. 7 except for a scattering layer AL3. The scattering layer AL3 includes main scattering particles DB1 and auxiliary scattering particles DB2, which are mixed with the base BS2. The main scattering particles DB1 may be substantially the same as the scattering particles DB1 described with reference to the embodiment shown in FIG. 7.

The main scattering particles DB1 and the auxiliary scattering particles DB2 may include the same material. The auxiliary scattering particles DB2 have a concentration that is the same as, or smaller than, a concentration of the main scattering particles DB1.

The main scattering particles DB1 have a size that is different from that of the auxiliary scattering particles DB2. For instance, the main scattering particles DB1 have a first size (e.g., first diameter) SZ1, and the auxiliary scattering particles DB2 have a second size (e.g., second diameter) SZ2 that is smaller than the first size SZ1.

The first size SZ1 of the main scattering particles DB1 may be greater than the wavelength of the light in the spectrum of visible light from about 390 nanometers to about 700 nanometers as described with reference to FIG. 7. For instance, the first size SZ1 of the main scattering particles DB1 may be equal to, or greater than, about 700 nanometers, and may be equal to, or smaller than, about 10 micrometers. Due to the main scattering particles DB1, an amount of the light forward-scattered in the traveling direction of the light provided from the display panel DP is greater than an amount of the light backward-scattered in the direction that is opposite to the traveling direction of the light. Accordingly, the efficiency of the light may not be reduced, and blurring of the image due to the scattering of the light may be reduced or prevented.

The second size SZ2 of the auxiliary scattering particles DB2 is equal to, or smaller than, about 1 micrometer. For instance, the second size SZ2 of the auxiliary scattering particles DB2 may be in a range from about 0.2 micrometers to about 1 micrometer. Accordingly, when the auxiliary scattering particles DB2 are compared with the main scattering particles DB1, in the auxiliary scattering particles DB2, a ratio of an amount of light scattered to the forward direction to an amount of incident light may be smaller than a ratio of an amount of light scattered to all directions to the amount of incident light. Accordingly, the sparkling phenomenon caused by excessive forward scattering of the light may be reduced as the auxiliary scattering particles DB2 are added to the filter SF3.

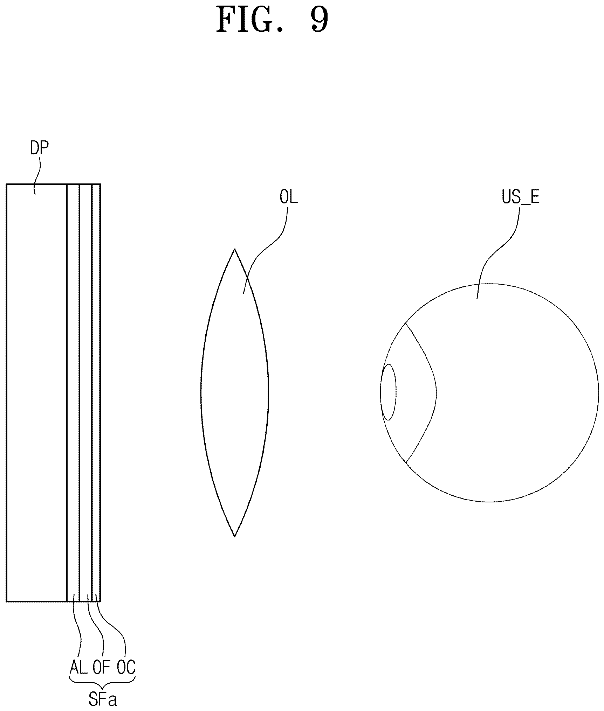

FIG. 9 is a cross-sectional view showing a head-mounted display device and a representation of eyes of a user according to an exemplary embodiment of the present disclosure.

Referring to FIG. 9, a filter SFa may further include a surface treatment layer OC located on a film OF.

The surface treatment layer OC may reduce a reflection occurring in the body part 100 (e.g., a reflection occurring between the display panel DP and the optical system OL). Accordingly, when the filter SFa including the surface treatment layer OC is attached to the display panel DP, a ghost image, which is otherwise caused by the reflection occurring in the body part 100, may be reduced or prevented from occurring.

In detail, the surface treatment layer OC may be, but is not limited to, a reflection prevention layer. The surface treatment layer OC may be an anti-glare layer that distributes the light to prevent the reflected light from being perceived, an antireflection layer that cancels out or absorbs the light to reduce or prevent reflection of the light, or a low-reflection layer. The surface treatment layer OC may have a structure in which a plurality of layers having different refractive indices are stacked one on another, a structure formed by coating a low-refractive-index material on the film, or a concavo-convex structure.

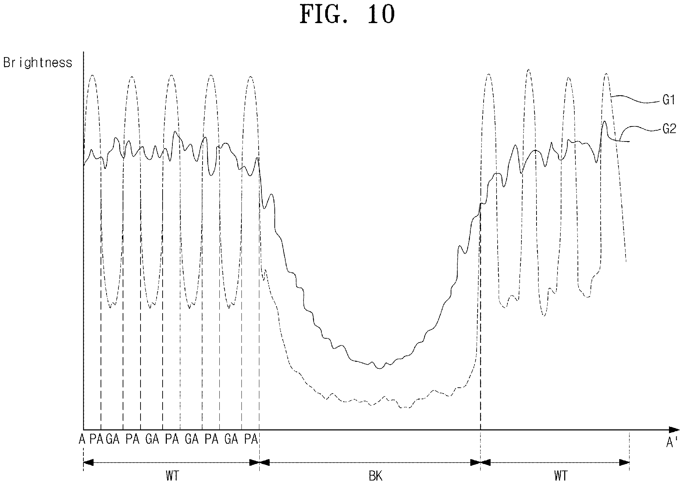

FIG. 10 is a graph showing a brightness variation as a function of a position variation on a display panel.

The graph shown in FIG. 10 shows the brightness variation measured along an imaginary line IL elongated from one point A to another point A' on the display panel DP of FIG. 5.

Referring to FIGS. 4, 5, and 10, a first graph G1 shows the brightness variation of the display panel DP to which the filter SF is not attached, and a second graph G2 shows the brightness variation of the display panel unit DU to which the filter SF is attached. In detail, the second graph G2 shows the brightness variation of the display panel unit DU when the filter SF having a haze value of about 90% is attached to the display panel DP. In should be noted that the haze value of the filter SF according to the present exemplary embodiment should not be limited to 90% in other embodiments.

The haze value of the filter SF is determined depending on a resolution of the display panel DP. For instance, as the resolution of the display panel DP increases, the haze value of the filter SF decreases. As an example, when assuming that the haze value of the filter SF attached to the display panel DP having an ultra high definition (UHD) resolution is about 50%, the haze value of the filter SF attached to the display panel DP having a full high definition (FHD) resolution is about 90%.

A first image WT and a second image BK may be alternately displayed through the display panel DP along the imaginary line IL. Each of the first and second images WT and BK may be displayed by a corresponding plurality of first, second, and third pixels PX1, PX2, and PX3. For instance, the first image WT may be a white image, and the second image BK may be a black image. In this case, the first, second, and third pixels PX1, PX2, and PX3 arranged in an area through which the first image WT is displayed provide the light, and the first, second, and third pixels PX1, PX2, and PX3 arranged in an area through which the second image BK is displayed do not provide the light.

According to the portion of the first graph G1 corresponding to the area through which the first image WT is displayed, a pixel area PA having a relatively high brightness and a non-pixel area GA having a relatively lower brightness are alternately defined with each other. Because the image provided from the display panel DP is magnified by the optical system OL, the non-pixel area GA is magnified along with the pixel area PA. Accordingly, the magnified non-pixel area GA may be perceived by the user, and as a result, the display quality of the head-mounted display device is degraded.

According to the second graph G2, the light provided from the pixel area PA is scattered by the filter SF, and thus, a difference in brightness between the pixel area PA and the non-pixel area GA may be reduced in the area through which the first image WT is displayed. Accordingly, although the image provided from the display panel unit DU is magnified by the optical system OL, the probability that the non-pixel area GA is perceived by the user is reduced. Thus, the display quality of the head-mounted display device HMD is improved.

The filter SF may serve as a resonance frequency filter. In more detail, the filter SF may serve as a low-pass filter that passes an image having a spatial frequency in a low frequency component. The spatial frequency of the first image WT and the second image BK, which are alternately repeated, is referred to as an image spatial frequency. The image spatial frequency may be lower than a spatial frequency of the pixel area PA and the non-pixel area GA, which are alternately repeated. Because the filter SF is attached to the display panel DP, a contrast ratio between the pixel area PA and the non-pixel area GA may be lowered. Accordingly, a boundary between the pixel area PA and the non-pixel area GA may not be perceived by the user.

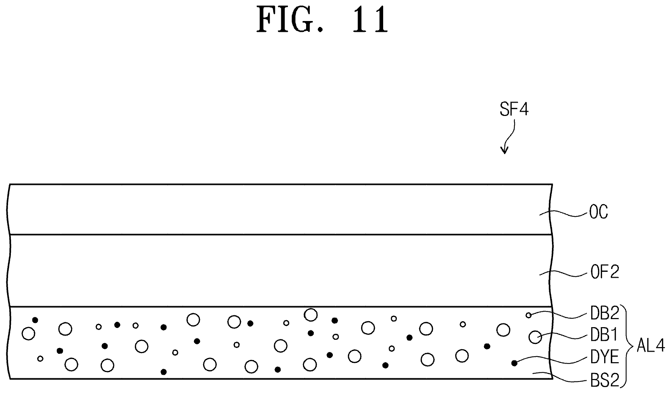

FIG. 11 is a cross-sectional view showing a filter SF4 according to an exemplary embodiment of the present disclosure.

Referring to FIG. 11, the filter SF4 has the same structure and function as the filter SF3 shown in FIG. 8 except for a scattering layer AL4. The scattering layer SF4 shown in FIG. 11 includes main scattering particles DB1, auxiliary scattering particles DB2, and dye particles DYE, which are mixed with the base BS2.

The dye particles DYE are colored particles. In more detail, the dye particles DYE are black particles. Due to the dye particles DYE, a contrast ratio of the image displayed through the display panel unit DP may be improved.

Because a transmittance is lowered as a weight percent (wt%) of the dye particles DYE increases, the weight percent (wt%) of the dye particles DYE is set in consideration of the transmittance. For instance, the transmittance of the scattering layer AL4 including the dye particles DYE is in a range from about 50% to about 90%, and in this case, the weight percent (wt%) of the dye particles DYE to the scattering layer AL4 is in a range from about 1 wt% to about 10 wt%, although the weight percent (wt%) of the dye particles DYE should not be limited thereto or thereby.

In FIG. 11, the dye particles DYE are included in the scattering layer AL4, but they should not be limited thereto or thereby. For instance, according to another embodiment, the dye particles DYE may be included in the film OF2 or in the surface treatment layer OC.

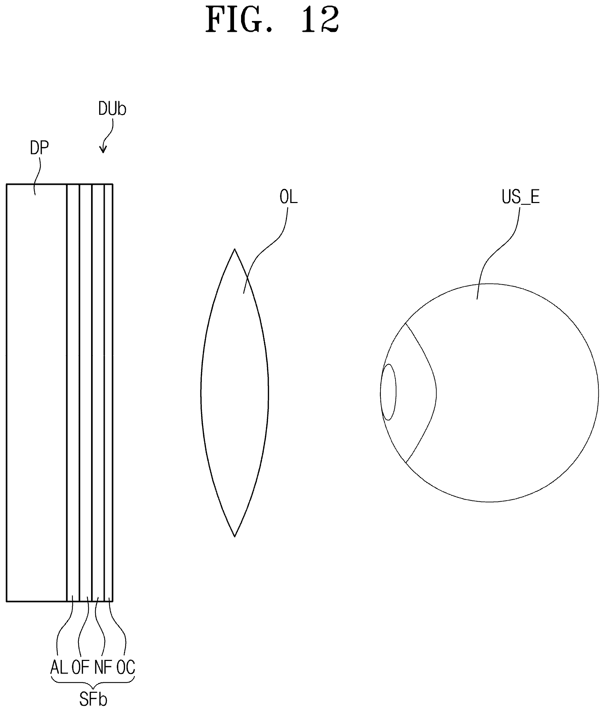

FIG. 12 is a cross-sectional view showing a head-mounted display device and a representation of eyes of a user according to an exemplary embodiment of the present disclosure.

Referring to FIG. 12, a filter SFb may further include a neutral density (ND) film NF. The ND film NF is between the film OF and the surface treatment layer OC. However, the position of the ND film NF may be changed in other embodiments of the present invention.

The ND film NF controls a transmittance of the light to improve a contrast ratio of the image displayed through the display panel DP. The ND film NF may be a film that reduces the transmittance of the light in a certain wavelength range, or may be a film that reduces the transmittance of the light in all of the wavelength ranges. The ND film NF may have the transmittance of about 40% or more. In more detail, the ND film NF has the transmittance in a range from about 40% to about 80%.

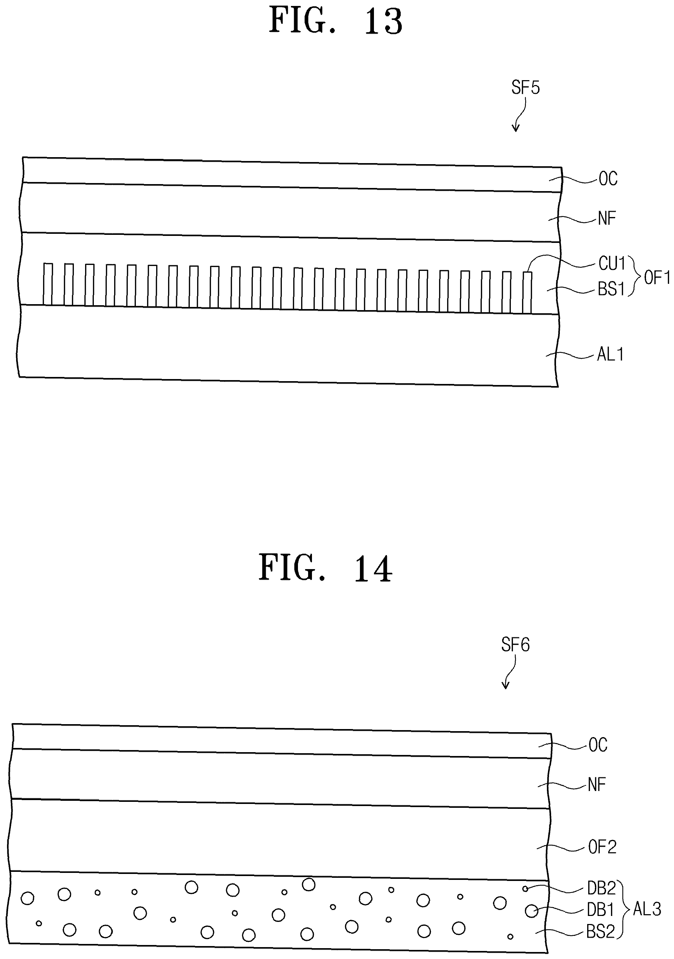

FIG. 13 is a cross-sectional view showing a filter SF5 according to an exemplary embodiment of the present disclosure, and FIG. 14 is a cross-sectional view showing a filter SF6 according to an exemplary embodiment of the present disclosure.

Referring to FIGS. 3, 13, and 14, the filter SF5 of the embodiment shown in FIG. 13 further includes the ND film NF and the surface treatment layer OC when compared with the filter SF1 of the embodiment shown in FIG. 6, and the filter SF6 of the embodiment shown in FIG. 14 further includes the ND film NF and the surface treatment layer OC when compared with the filter SF3 of the embodiment shown in FIG. 8.

The ND film NF controls the transmittance of the light to improve the image displayed through the display panel unit DU. The surface treatment layer OC reduces or prevents generation of a ghost image otherwise caused by internal reflection of the body part 100.

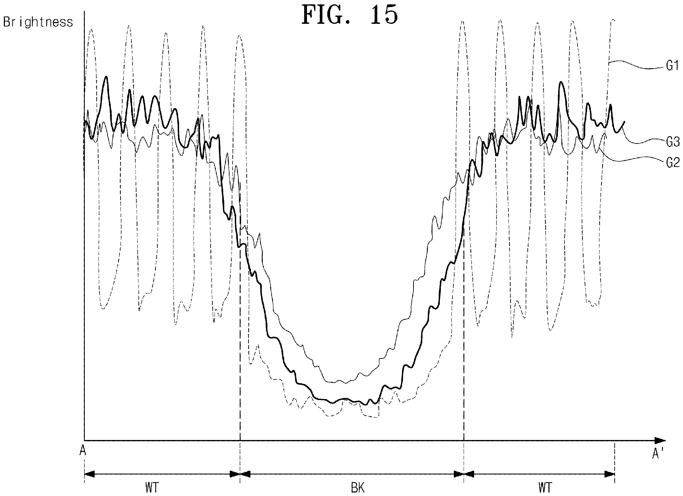

FIG. 15 is a graph showing a brightness variation as a function of a position variation on a display panel.

Referring to FIGS. 3, 5, and 15, a first graph G1 shows the brightness variation of a display panel unit in which a filter is not included, and a second graph G2 shows the brightness variation of the display panel unit DU including one of the filters SF1, SF2, and SF3 shown in FIGS. 6 to 8. A third graph G3 shows the brightness variation of the display panel unit DU including one of the filters SF4, SF5, and SF6 shown in FIGS. 11, 13, and 14.

When the second and third graphs G2 and G3 are compared with the first graph G1, the brightness variation in the area where the first image WT is displayed may be reduced, as represented by the second and third graphs G2 and G3. Accordingly, although the image is magnified by the optical system OL, the probability that the non-pixel area GA is perceived by the user may be reduced in the display panel unit DU including one of the filters SF1, SF2, SF3, SF4, SF5, and SF6 respectively shown in FIGS. 6, 7, 8, 11, 13, and 14. Thus, the display quality of the head-mounted display device HMD may be improved.

When the second graph G2 is compared with the third graph G3, a difference in brightness exists in the area in which the second image BK is displayed. The filters SF4, SF5, and SF6 respectively shown in FIGS. 11, 13, and 14 include the dye particles DYE and/or the ND filter NF. Accordingly, the filters SF4, SF5, and SF6 respectively shown in FIGS. 11, 13, and 14 reduce the transmittance of the light, and thus, the brightness of the second image BK may be more reduced. Thus, when the display panel unit DU displays the image having low brightness (e.g., a black image), the display panel unit DU may display a screen with the black or low brightness value.

Although the exemplary embodiments of the present invention have been described, it is understood that the present invention should not be limited to these exemplary embodiments but various changes and modifications can be made by one ordinary skilled in the art within the scope of the present invention as hereinafter claimed by the following claims and their functional equivalents.

## Claims

1. A head-mounted display device (HMD) comprising:
a display panel (DP) comprising a plurality of pixels (PX1, PX2, PX3) for displaying an image;
a filter (SF, SF1, SF2, SF3, SF4, SF5, SF6) on the display panel, and comprising a scattering layer (OF1, AL2, AL3, AL4) for scattering the image to generate a scattered image, the scattering layer (OF1, AL2, AL3, AL4) comprising:
a base (BS1, BS2) having a first refractive index; and
scattering particles (CU1, DB1) located inside the base (BS1, BS2) and having a second refractive index that is greater than the first refractive index; and
an optical system (OL) in front of the filter (SF, SF1, SF2, SF3, SF4, SF5, SF6) for magnifying the scattered image.

2. The head-mounted display device of claim 1, wherein the filter (SF, SF1, SF2, SF3, SF4, SF5, SF6) further comprises a surface treatment layer (OC) on the scattering layer (OF1, AL2, AL3, AL4) for reducing a reflection occurring between the display panel DP and the optical system OL.

3. The head-mounted display device of claim 1 or claim 2, wherein the filter (SF, SF1, SF2, SF3, SF4, SF5, SF6) further comprises a neutral density film layer (NF) on the scattering layer (OF1, AL2, AL3, AL4).

4. The head-mounted display device of one of the preceding claims, wherein each of the scattering particles (CU1) has a bar shape elongated along a direction perpendicular to a surface of the display panel (DP).

5. The head-mounted display device of claim 4, wherein the base (BS1) comprises a urethane methacrylate oligomer, and the scattering particles (CU1) comprise ethoxylated o-phenylphenol acrylate.

6. The head-mounted display device of one of claims 4 and 5, wherein the scattering particles (CU1) are spaced apart from each other by a distance ranging from 3µm to 4µm.

7. The head-mounted display device of one of claims 1 to 3, wherein each of the scattering particles (DB1, DB2) has a bead shape.

8. The head-mounted display device of claim 7, wherein the scattering particles (DB1) comprise main scattering particles (DB1) having a first size that is smaller than a size of a smallest pixel among the pixels (PX1, PX2, PX3), and that is greater than 700nm.

9. The head-mounted display device of claim 8, wherein the scattering particles further comprise auxiliary scattering particles (DB2) having a second size that is smaller than the first size.

10. The head-mounted display device of claim 9, wherein the second size is smaller than 1µm.

11. The head-mounted display device of one of claims 9 and 10, wherein a concentration of the main scattering particles (DB1) is higher than a concentration of the auxiliary scattering particles (DB2).

12. The head-mounted display device of one of claims 7 to 11, wherein the base (BS2) comprises poly-butyl acrylate, and
wherein the scattering particles (DB1, DB2) comprise one of melamine, polystyrene, polymethyl methacrylate, polylactide, silicon oxide, and metal oxide.

13. The head-mounted display device of one of claims 7 to 12, wherein the scattering layer (AL4) further comprises dye particles (DYE) mixed with the base (BS2).

14. The head-mounted display device of one of claims 7 to 13, wherein the filter (SF, SF2, SF3, SF4, SF6) further comprises a film (OF, OF2) on the scattering layer (AL2, AL3, AL4), and wherein the film (OF, OF2) is a transparent film.

15. The head-mounted display device of claim 14, wherein the film (OF, OF2) is a colored transparent film.
